# EUROPEAN PATENT APPLICATION

(11) **EP 3 785 794 A1**
(43) Date of publication of application: **03.03.2021**
(21) Application number: 19792451.7
(22) Date of filing: 04.03.2019
(51) Int. Cl.: B01J 19/00, C08F 290/06, C08F 299/08, G01N 37/00

(54) **MICROCHANNEL CONSTITUTED OF HYDROPHILIC SILICONE RESIN**

(30) Priority: 27.04.2018 JP 2018086353
(71) Applicant: Shin-Etsu Chemical Co., Ltd., Tokyo 100-0004 (JP)
(72) Inventor: HAGIWARA Mamoru, Annaka-shi, Gunma 379-0224 (JP)
(74) Representative: Wibbelmann, Jobst
(86) International application number: PCT/JP2019/008402
(87) International publication number: WO 2019/207960

(57) **Abstract**

The present invention is a microfluidic channel made of a hydrophilic silicone resin comprising a crosslinked material obtained by curing a composition containing a silicone macromer represented by the following general formula (1). Consequently, a microfluidic channel made from a resin having high oxygen permeability, where a surface after formation shows high hydrophilicity without a secondary treatment and the hydrophilicity is sustained for a long period of time is provided.

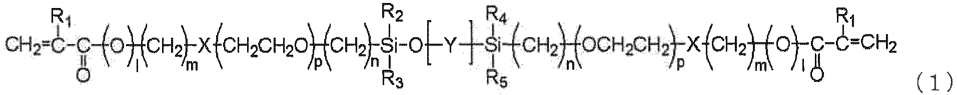

## Description

### TECHNICAL FIELD

The present invention relates to a microfluidic channel that can handle a minute amount at a constant flow rate in a fluidic channel member of a blood analyzer, a fluidic channel member in a cell culture equipment, and the like.

### BACKGROUND ART

A micro total analysis system (µTAS) having a minute fluidic channel, a pump, and a reaction chamber, etc. integrated on a single substrate is attracting attention as a means of inspection and diagnosis in the field of medicine and as a means of synthesis and analysis in the field of chemistry. For example, when a microfluidic channel equipment having a minute fluidic channel formed inside a substrate is used, various operations such as reaction, extraction, separation, and measurement can be performed with an extremely small amount of sample in a short time. Glass and resins are known as materials for a substrate. In particular, silicone resins are easily microprocessed and excellent in light permeability, and are useful for these reasons.

However, a substrate made of a silicone resin has a low affinity to water. Accordingly, when a liquid containing water is poured into a fluidic channel, it may not be possible to perform a desired operation accurately due to poor flow property. In addition, a substance in a reagent or a specimen liquid may be adsorbed onto a surface of the fluidic channel. In this case, the fluidic channel is narrowed by the adsorbed substance and flow rate becomes unstable, and in addition, accuracy in the analysis becomes lowered due to loss of the reagent or the like. Consequently, it is necessary to hydrophilize the fluidic channel surface.

Furthermore, a fluidic channel constituted from only general silicone resins has a hydrophobic fluidic channel surface. Therefore, there have also been problems from a device aspect, for example, a bubble generated when the pressure inside the fluidic channel changes remains on an inner wall and the bubble cannot be removed even if the flow rate is subsequently raised.

From the above-described problems, various studies have been made to hydrophilize the inner surface of a fluidic channel in a device formed from a silicone resin.

Patent Document 1 discloses a method for hydrophilizing a fluidic channel surface by disposing a pair of electrodes via a dielectric substance on a fluidic channel formed on a substrate, and supplying plasma produced by applying a high-frequency voltage between the electrodes into the fluidic channel.

Meanwhile, Patent Documents 2 and 3 disclose methods of raising wettability of a fluidic channel surface by treating the fluidic channel surface with a solution containing hydrophilic polymer, etc.

Meanwhile, Patent Document 4 discloses a method of fabricating a microfluidic channel with an acrylic resin or glass as a base, and making the inside of the fluidic channel hydrophilic by coating the surface with a hydrophilic polymer as a secondary treatment.

In the method of Patent Document 1, the fluidic channel surface is hydrophilized by forming a hydroxy group or an amino group thereon.

However, the hydrophilicity cannot be said to be sufficient, and although the fluidic channel surface shows hydrophilicity immediately after the hydrophilization treatment, hydrophilicity is lost with the passage of time, and reverts to hydrophobicity. Similarly, hydrophilicity is also not easily sustained in the method of Patent Document 2. In addition, in the methods of Patent Documents 2 and 3, it is difficult to control the thickness of a film that is formed on the fluidic channel surface since the hydrophilization treatment is performed by pouring a solution after forming the fluidic channel. For example, if the film becomes thick, the fluidic channel volume decreases accordingly, and therefore, accuracy of analysis, etc. is remarkably lowered.

In the method of Patent Document 4, a surface having durability and favorable wettability can be obtained, but there has been no study into the silicone resin base material. Therefore, when this is used for a cell culture device or the like that requires an oxygen supply, the oxygen supply to the fluidic channel becomes insufficient since the base material has a low oxygen permeability, and the optimum fluidic channel cannot be obtained.

### CITATION LIST

### PATENT LITERATURE

Patent Document 1: Japanese Unexamined Patent
   Application Publication No. 2006-205055
Patent Document 2: Japanese Unexamined Patent
   Application Publication No. 2006-292472
Patent Document 3: Japanese Unexamined Patent
   Application Publication No. 2008-82961
Patent Document 4: Japanese Unexamined Patent
   Application Publication No. 2010-236955

### SUMMARY OF INVENTION

### TECHNICAL PROBLEM

The present invention has been made in view of such circumstances, and an object thereof is to provide a microfluidic channel made from a resin having high oxygen permeability, where a surface after formation shows high hydrophilicity without a secondary treatment and the hydrophilicity is sustained for a long period of time.

### SOLUTION TO PROBLEM

To achieve the object, the present invention provides a microfluidic channel made of a hydrophilic silicone resin comprising a crosslinked material obtained by curing a composition containing a silicone macromer represented by the following general formula (1), 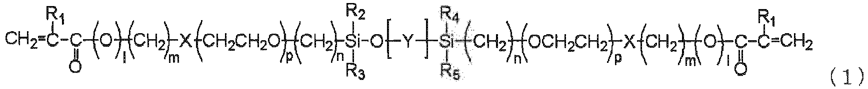 wherein R₁ represents a hydrogen atom or a methyl group; R₂ to R₅ each represents a hydrocarbon group having 1 to 12 carbon atoms or a trimethylsiloxy group; Y consists of structural units (I) to (III) shown in the following general formula (2), where content ratios of the structural units are (I)/(II)=5/5 to 10/0 and [(I)+(II)]/(III)=100/1 to 0/100, and a total number of the structural units contained is (I)+(II)+(III)=1 to 300; "m" and "n" are each an identical or different integer of 0 to 20; "p" is an integer of 0 to 20; "l" is 0 when "m" is 0, and "l" is 1 when "m" is 1 or more; and X represents a single bond, -NHCOO-, or a divalent linking group of -OOCHN-R₁₃-NHCOO- where R₁₃ represents a hydrocarbon group having 4 to 13 carbon atoms, 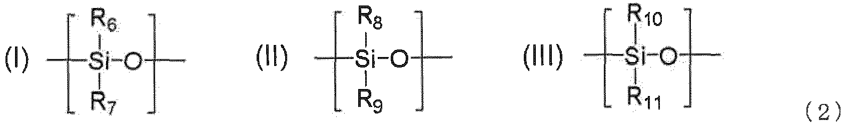 wherein R₆ and R₇ each represents a hydrocarbon group having 1 to 12 carbon atoms; R₈ and R₉ each represents a hydrocarbon group or a hydrocarbon group substituted with a fluorine atom having 1 to 12 carbon atoms, where at least one of R₈ and R₉ represents a hydrocarbon group substituted with a fluorine atom; and R₁₀ and R₁₁ each represents a hydrocarbon group having 1 to 12 carbon atoms or a polyalkyleneoxy group shown in the following general formula (3) where "q" is an integer of 0 to 20 and R₁₂ represents a hydrogen atom or a hydrocarbon group having 1 to 20 carbon atoms, where at least one of R₁₀ and R₁₁ represents a polyalkyleneoxy group.

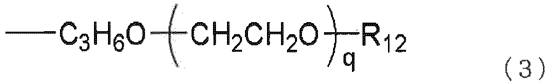

Such a microfluidic channel made of a hydrophilic silicone resin can be made from a resin having high oxygen permeability, where a surface after formation shows high hydrophilicity without a secondary treatment and the hydrophilicity is sustained for a long period of time.

Furthermore, the composition preferably contains one or more kinds of monomers that are copolymerizable with the silicone macromer.

In this event, the one or more kinds of copolymerizable monomers are preferably one or more kinds of monomers selected from a (meth)acrylate monomer, an N,N-dimethyl(meth)acrylamide monomer, a 2-hydroxyethyl(meth)acrylate monomer, a glycerol(meth)acrylate monomer, a 2-hydroxyethyl(meth)acrylamide monomer, a polyethylene glycol mono(meth)acrylate monomer, an N-vinyl pyrrolidone, and a polyethylene glycol di(meth)acrylate monomer.

This allows a favorable characteristic balance of optical characteristics, oxygen permeability, mechanical strength, water wettability, dimensional stability at the time of formation and the change thereof over time, etc. of the microfluidic channel base material.

Furthermore, an underwater contact angle of the crosslinked material is preferably 110° or more.

When the underwater contact angle is as described, the inventive microfluidic channel made of a hydrophilic silicone resin shows a more sufficient hydrophilicity and water wettability.

Furthermore, an oxygen permeation coefficient of the crosslinked material is preferably 50 barrers or more.

When the oxygen permeation coefficient is as described, a more sufficient supply of oxygen to the fluidic channel is possible even when the inventive microfluidic channel made of a hydrophilic silicone resin is used for a cell culture device, etc. that requires a supply of oxygen.

### ADVANTAGEOUS EFFECTS OF INVENTION

According to the present invention, a microfluidic channel can be provided by an industrially easy method, and the microfluidic channel can solve the above problems of achieving and sustaining hydrophilicity inside the fluidic channel without a secondary surface treatment and the problem of oxygen permeability of a resin, where a bubble does not remain on the microfluidic channel surface even when one gets mixed in, and the microfluidic channel does not inhibit a supply of oxygen to a cell. In addition, the present invention is particularly suitable for a fluidic channel member in a blood analyzer, a fluidic channel member of an equipment for cell culture, and the like.

### BRIEF DESCRIPTION OF DRAWINGS

FIG. 1 is a 1H-NMR spectrum of a siloxane macromer (macromer A) obtained in Example 1.
FIG. 2 is an IR spectrum of a siloxane macromer (macromer A) obtained in Example 1.
FIG. 3 is a diagram roughly showing a captive bubble method.

### DESCRIPTION OF EMBODIMENTS

As described above, development of a microfluidic channel made from a resin having high oxygen permeability, where a surface after formation shows high hydrophilicity without a secondary treatment and the hydrophilicity is sustained for a long period of time has been desired.

The present inventor has earnestly studied the above problems, and found out that by using a silicone macromer containing a structural unit having a polyalkyleneoxy group on a side chain of a siloxanyl group as a material for a microfluidic channel, a microfluidic channel having high hydrophilicity in a fluidic channel inner wall despite being made of a silicone resin, and also having favorable oxygen permeability can be fabricated, and completed the present invention.

That is, the present invention is a microfluidic channel made of a hydrophilic silicone resin comprising a crosslinked material obtained by curing a composition containing a silicone macromer represented by the above general formula (1).

Hereinafter, the present invention will be described in detail, but the present invention is not limited thereto.

The inventive microfluidic channel made of a hydrophilic silicone resin is for pouring a minute amount of sample, preferably a sample in liquid form, and a size and length of the microfluidic channel are not particularly limited as long as an object thereof (to handle a minute amount at a constant flow rate) can be achieved appropriately. The inventive microfluidic channel preferably has a fluidic channel diameter of 1 µm to 10 mm for a sample to pass through, further preferably having a fluidic channel diameter of 10 µm to 1 mm. The size of the fluidic channel diameter of the microfluidic channel may be the same over the whole length, but may also have a partially different shape and size. That is, there may be a portion that becomes thinner or thicker gradually or in stages.

A surface of a microfluidic channel means an inner wall of the microfluidic channel, and the inventive microfluidic channel made of a hydrophilic silicone resin has a surface (inner wall) that shows high hydrophilicity and water wettability. In addition, since the crosslinked material itself that is to be a base material of the microfluidic channel has hydrophilicity, there is no need to perform a hydrophilization treatment on the fluidic channel surface as in conventional technology. Consequently, the inventive microfluidic channel made of a hydrophilic silicone resin does not lose hydrophilicity with the passage of time as in a case where a hydrophilization treatment has been performed, and therefore, hydrophilicity can be sustained over a long period of time.

The base material for fabricating the inventive microfluidic channel made of a hydrophilic silicone resin contains a crosslinked material obtained by curing a composition containing a silicone macromer represented by the following general formula (1), 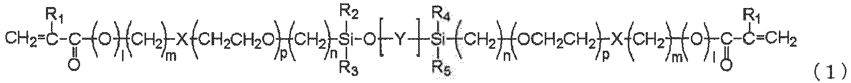 where R₁ represents a hydrogen atom or a methyl group; R₂ to R₈ each represents a hydrocarbon group having 1 to 12 carbon atoms or a trimethylsiloxy group; Y consists of structural units (I) to (III) shown in the following general formula (2), where content ratios of the structural units are (I)/(II)=5/5 to 10/0 and [(I)+(II)]/(III)=100/1 to 0/100, and a total number of the structural units contained is (I)+(II)+(III)=1 to 300; "m" and "n" are each an identical or different integer of 0 to 20; "p" is an integer of 0 to 20; "l" is 0 when "m" is 0, and "l" is 1 when "m" is 1 or more; and X represents a single bond, -NHCOO-, or a divalent linking group of -OOCHN-R₁₃-NHCOO- where R₁₃ represents a hydrocarbon group having 4 to 13 carbon atoms, 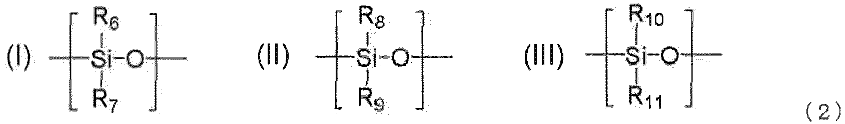 where R₆ and R₇ each represents a hydrocarbon group having 1 to 12 carbon atoms; R₈ and R₉ each represents a hydrocarbon group or a hydrocarbon group substituted with a fluorine atom having 1 to 12 carbon atoms, where at least one of R₈ and R₉ represents a hydrocarbon group substituted with a fluorine atom; and R₁₀ and R₁₁ each represents a hydrocarbon group having 1 to 12 carbon atoms or a polyalkyleneoxy group shown in the following general formula (3) where "q" is an integer of 0 to 20 and R₁₂ represents a hydrogen atom or a hydrocarbon group having 1 to 20 carbon atoms, where at least one of R₁₀ and R₁₁ represents a polyalkyleneoxy group.

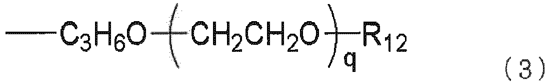

When the molecular weight of the siloxane macromer represented by the general formula (1) is increased, the length of the chains between the functional groups of the main chain becomes long if the number of functional groups in the side chain is the same, and therefore, cohesive energy is reduced, and at the same time, glass transition points are also reduced. Accordingly, the siloxane macromer has a great effect on physical properties shown by softness and rubber elasticity when fabricating a microfluidic channel device.

In the general formula (1), R₁ represents a hydrogen atom or a methyl group, R₂, R₃, R₄ and R₅ each represents a hydrocarbon group having 1 to 12 carbon atoms, or a trimethylsiloxy group where each may be the same or different. R₂ to R₅ are preferably hydrocarbon groups having 1 to 3 carbon atoms from viewpoints of elasticity, strength, etc. when fabricating a microfluidic channel device. "m" and "n" are integers of 0 to 20 and "p" is an integer of 0 to 20, and if each exceeds 20, compatibility with other monomers becomes poor, and clouding is becomes liable to occur. "l" is 0 when "m" is 0, and "l" is 1 when "m" is 1 or more.

The structure of Y in the general formula (1), Y being a siloxanyl unit of the macromer that determines the molecular weight of the silicone macromer represented by the general formula (1), consists of the structural units shown by (I), (II) and (III) in the general formula (2). The structural units (I), (II) and (III) each has the following characteristics.

In the structural unit (I), the side chains of the siloxanyl group are hydrocarbon groups having 1 to 12 carbon atoms, and the structural unit (I) has an effect of increasing oxygen permeability (that is, an oxygen permeation coefficient) as the number of structural units (I) increases in the molecule. The structural unit (I) also has an effect of reducing a glass transition point, and is therefore a structural unit that provides favorable mechanical properties. When the structural units (I) are not present successively in a molecule, adsorption of a chemical or a protein poured in the fluidic channel becomes more difficult to occur, and accumulation of the chemical or the protein in the fluidic channel inner wall can be suppressed.

Next, in the structural unit (II), at least one of the side chains of the siloxanyl group is a hydrocarbon group substituted with a fluorine atom, and by having on a side chain a hydrocarbon group substituted with a fluorine atom, a decrease in critical surface tension caused by a fluorine atom occurs. This has an effect of suppressing contamination of the fluidic channel inner wall by a protein, a lipid, or an inorganic component, etc., and has a characteristic that even when a contaminant adheres, the contaminant easily comes off. However, the structural unit (II) does not have as much tendency to increase oxygen permeability as the structural unit (I), and therefore, if too many are present in a molecule, it becomes difficult to obtain a desired oxygen permeability. In addition, since the structural unit (II) has an effect of making the fluidic channel inner wall hydrophobic, there is danger of wettability being lowered. For this reason, the content ratio (structural unit (I)/structural unit (II)) is controlled to be within a predetermined range as described below.

The structural unit (III) is a particularly essential structural unit to the present invention that brings high hydrophilicity and water wettability in the fluidic channel by having a polyalkyleneoxy group shown by the general formula (3) on at least one side chain of the siloxanyl group. The inventive microfluidic channel can be made to have higher oxygen permeability and higher hardness by controlling the content (content ratio and number of structural units) of the structural unit (III) in a molecule as described below.

As described above, the balance of the content ratio of the structural units (I), (II) and (III) present in a molecule affects the performance of the inventive microfluidic channel, and if the content ratio and the total number of these structural units (I) to (III) do not satisfy the following relation, the macromer itself may be obtained in a clouded state, compatibility with a copolymerizable monomer may be degraded and cause phase separation, or clouding may occur at the time of polymerization. For the above reasons, the structural units (I) and (II) contained in a molecule are present at a ratio (content ratio) where the ratio of structural unit (I):structural unit (II) is 5:5 to 10:0, preferably 7:3 to 9:1, and the total number of the contained structural units (I), (II), and (III) is 1 to 300, preferably 10 to 200.

The content ratio of the structural unit (III) contained in the molecule is expressed as a ratio to the total number of the structural units (I) and (II), and the ratio of structural unit (I)+(II):structural unit (III) is 100:1 to 0:100, preferably 100:2 to 100:10.

The side chains of the siloxanyl group in the structural unit (I) are each a hydrocarbon group having 1 to 12 carbon atoms, preferably a methyl group. At least one of the side chains of the siloxanyl group in the structural unit (II) needs to be a hydrocarbon group substituted with a fluorine, the hydrocarbon group including, for example, a 3,3,3-trifluoropropyl group, a 1,1,2,2-tetrahydroperfluorooctyl group, a 1,1,2,2-tetrahydroperfluorodecyl group and the like, and in particular, a trifluoropropyl group is preferable. At least one of the side chains of the siloxanyl group in the structural unit (III) needs to be a polyalkyleneoxy group, and a terminal is preferably capped with an alkyl group from the viewpoint of suppressing side reaction on manufacturing. A structure of a polyethylene glycol chain with a length of 3 to 10 with a methoxy group as the terminal (that is, the terminal is capped with a methyl group) is more preferable.

Next, the X in the general formula (1) represents a single bond, -NHCOO-, or a divalent linking group of - OOCHN-R₁₃-NHCOO- where R₁₃ represents a hydrocarbon group having 4 to 13 carbon atoms, and the hydrocarbon group is, for example, an aliphatic hydrocarbon group, an alicyclic hydrocarbon group, or an aromatic hydrocarbon group). Strength and water wettability can be further improved by containing these urethane bonds in a molecular structure. Examples of a residue of a bifunctional isocyanate include residues such as hexamethylene diisocyanate, tetramethylene diisocyanate, 2,4,4-trimethyl-1,6-hexamethylene diisocyanate, 2,6-diisocyanatemethylcaproate, 3-isocyanatemethyl-3,5,5-trimethylcyclohexylisocyanate, dicyclohexylmethane-4,4'-diisocyanate, hydrogenated xylylene diisocyanate, hydrogenated tolylene diisocyanate, isophorone diisocyanate, and in particular, residues of hexamethylene diisocyanate and isophorone diisocyanate are preferable.

The siloxane macromer represented by the general formula (1) is obtained by, for example, synthesizing a diol compound having a polysiloxane structure obtained by an equilibration reaction of α,ω-bis-(1-hydroxyethoxypropyl) dimethylpolysiloxane with octamethylcyclotetrasiloxane, 1,3,5-trimethyltrifluoropropylcyclotrisiloxane, and tetramethylcyclotetrasiloxane, and then going through a hydrosilylation reaction with α-monoallyloxyalkyleneoxide, and performing a reaction between a hydroxy group and an equivalent of isocyanateethylmethacrylate. The structure of this obtained siloxane macromer can be analyzed from an NMR (nuclear magnetic resonance spectrum) and an IR absorption spectrum.

In addition, the abundance ratio and the existing number of the structural units (I), (II) and (III) contained in a molecule can be obtained by measuring the NMR (nuclear magnetic resonance spectrum). For example, when the structural unit (I) is dimethylsiloxane, the structural unit (II) is methyl-trifluoropropylsiloxane, and the structural unit (III) is methoxy polyethylene glycol, the abundance ratio and the existing number of the structural units can be obtained by measuring the integrated value of proton absorption regarding a methyl group, a trifluoropropyl group, and an ethylene glycol group that appear on an NMR spectrum, and further measuring the integrated value of proton absorption regarding a methylene group contained in the same molecule.

The types of the constitutional units and the number of bonds constituting the Y in the general formula (1), and the residue constituting the X are selected in accordance with the target performance of the microfluidic channel base material, for example the required strength, softness, oxygen permeability, and the water wettability of the inner wall, etc.

The inventive microfluidic channel made of a hydrophilic silicone resin consists of a crosslinked material obtained by curing a composition containing a silicone macromer represented by the above general formula (1). Besides the silicone macromer represented by the general formula (1), the composition may contain a photopolymerization initiator, an azo compound or an organic peroxide for obtaining the crosslinked material by polymerizing and curing the silicone macromer. Furthermore, as described below, one or more kinds of monomers that are copolymerizable with a siloxane macromer may be contained.

The composition containing the silicone macromer represented by the general formula (1) preferably contains one or more kinds of monomers that are copolymerizable with the silicone macromer.

In this event, the one or more kinds of copolymerizable monomers are preferably one or more kinds of monomers selected from a (meth)acrylate monomer, an N,N-dimethyl(meth)acrylamide monomer, a 2-hydroxyethyl(meth)acrylate monomer, a glycerol(meth)acrylate monomer, a 2-hydroxyethyl(meth)acrylamide monomer, a polyethylene glycol mono(meth)acrylate monomer, an N-vinyl pyrrolidone, and a polyethylene glycol di(meth)acrylate monomer.

To enhance mechanical properties, surface water wettability, and dimensional stability, etc. as desired, the following monomers may be copolymerized. Examples of monomers for enhancing mechanical properties include aromatic vinyl compound such as styrene, tert-butyl styrene, and α-methyl styrene. Examples of monomers for enhancing surface wettability include methacrylic acid, acrylic acid, itaconic acid, 2-hydroxyethyl methacrylate, 2-hydroxypropyl methacrylate, glycidyl methacrylate, glycerol methacrylate, polyethylene glycol methacrylate, N,N'-dimethylacrylamide, N,N'-diethylacrylamide, N-methylacrylamide, dimethylaminoethyl methacrylate, methylenebisacrylamide, N-vinyl pyrrolidone, and N-vinyl N methylacetamide.

Examples of monomers for enhancing dimensional stability include ethylene glycol dimethacrylate, diethylene glycol dimethacrylate, triethylene glycol dimethacrylate, polyethylene glycol dimethacrylate, trimethylol propane trimethacrylate, pentaerythritol tetramethacrylate, bisphenol A dimethacrylate, vinyl methacrylate, and acrylic methacrylate; and acrylates corresponding to these methacrylates, divinyl benzene, and triallyl isocyanurate. These monomers may be used alone or in combination of two kinds or more. To achieve a favorable characteristic balance of optical characteristics, oxygen permeability, mechanical strength, water wettability, dimensional stability at the time of formation and the change thereof over time, etc. of the microfluidic channel base material, a mixed monomer achieved by combining these copolymerizable monomers can be used.

As a method for curing such a composition to obtain a crosslinked material, either one of a method of making a photopolymerization initiator present in a monomer mixture and polymerizing by irradiating with an ultraviolet ray or a method of thermal polymerizing using an azo compound or an organic peroxide can be applied.

Furthermore, an underwater contact angle of the crosslinked material obtained by curing the composition is preferably 110° or more.

When the underwater contact angle is as described, the inventive microfluidic channel shows a more sufficient hydrophilicity and water wettability.

Furthermore, an oxygen permeation coefficient of the crosslinked material obtained by curing the composition is preferably 50 barrers or more.

When the oxygen permeation coefficient is as described, a more sufficient supply of oxygen to the fluidic channel is possible even when the inventive microfluidic channel is used for a cell culture device, etc. that requires a supply of oxygen.

### EXAMPLE

Next, the present invention will be described in further detail with reference to Examples, but the present invention is not limited to these Examples in any way. Note that molecular weight, each physical property, and characteristics of the obtained materials were obtained as follows.

(1) Molecular structure and molecular weight were obtained by NMR and GPC.
(2) Oxygen permeation coefficient

A gas permeability measurement equipment K-315-N manufactured by Rikaseiki Co. Ltd. was used. The sample pieces had a diameter of 30 mm, a thickness of 0.3 to 0.5 mm, were disk-shaped, and were measured at a constant temperature of 25°C.

### (3) Mechanical properties

A tensile tester 5942B-1156 manufactured by Instron was used to measure tensile strength, elongation, and modulus of elasticity from the initial stress. The measurement was conducted in a thermostatic chamber at 25°C and test pieces having 8 mm, a width of 4 mm, a length of 50 mm, and a thickness of 0.3 to 0.5 mm were used.

### (4) Measurement of contact angle in liquid

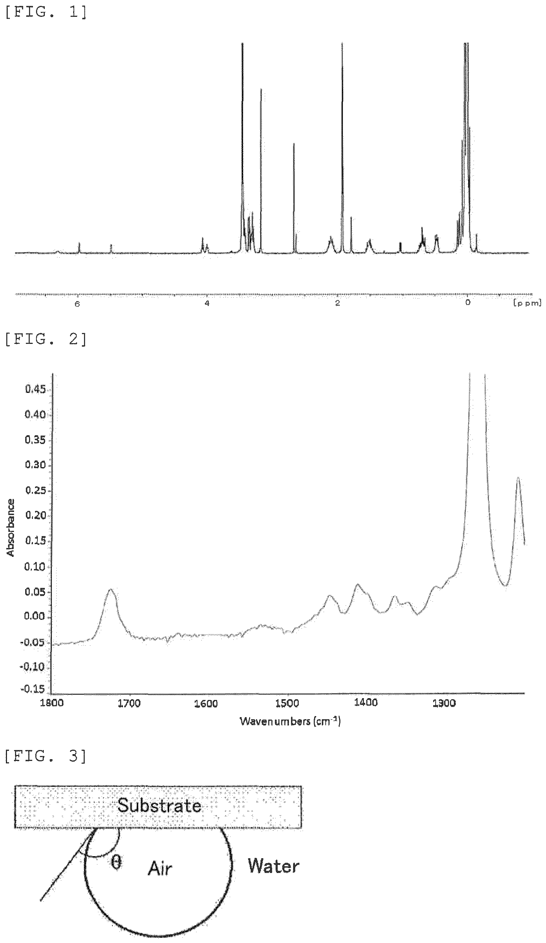

Contact angle in liquid was obtained by a captive bubble method of making a bubble come into contact with a test piece surface under water using a DSA-25S manufactured by KRUSS (see FIG. 3). In FIG. 3, a larger contact angle θ means the substrate surface has higher hydrophilicity. The contact angle θ was measured by making a bubble of 5 µL come into contact with the surface under water in room temperature under normal pressure.

### (5) Fabrication of microfluidic channel and evaluation of bubble separation property

Using a known lithography technology, the microfluidic channels were fabricated by sticking together single-sided circuit substrates obtained by an imprinting method from the cured material of each material. The evaluation was performed by first judging whether or not a microfluidic channel can be fabricated from steps such as demolding, and then, regarding those that were fabricable, bubble separation property was visually evaluated by a liquid feeding test.

### [Example 1]

### (Synthesis of Macromer A)

46 g of KF-6001 (available from Shin-Etsu Chemical Co., Ltd.), 133 g of octamethylcyclotetrasiloxane, 28 g of 1,3,5-trimethyltrifluoropropylcyclotrisiloxane, 6.5 g of 1,3,5,7-tetramethylcyclotetrasiloxane, 234 g of chloroform, and 1.9 g of trifluoromethanesulfonic acid were charged into a flask and reaction was conducted at 40°C for 15 Hr.

Subsequently, after neutralizing by adsorbing acid with celite, the solution was refined by distilling off under reduced pressure and dissolved in 191 g of isopropyl alcohol, and a hydrosilylation reaction with 40.8 g of PKA-5007 (available from NOF Corporation) was performed in the presence of 0.16 g of a platinum catalyst. The obtained reaction solution was repeatedly dissolve-cleaned with an 80% aqueous methanol solution, and then solvent-distilling was performed to obtain 136 g of siloxanediol having a hydroxy group on both terminals. The obtained siloxanediol was subjected to an NMR (nuclear magnetic resonance spectrum) analysis, and as a result, it was observed that the siloxanediol had the structure shown in the following formula.

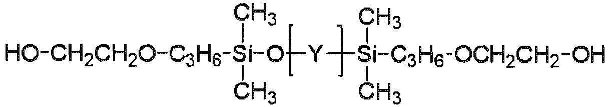

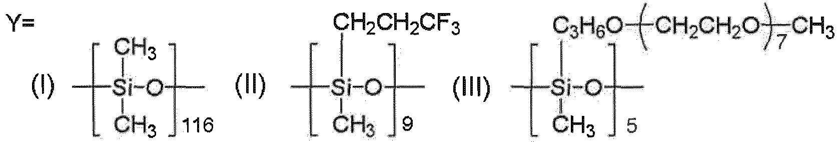

125 g of this siloxanediol, 0.06 g of BHT, 0.25 g of MQ, 9.8 g of 2-isocyanateethyl methacrylate (available from Showa Denko K.K.), and 0.013 g of Ferric (III) acetylacetonate were charged into a flask, and reaction was conducted at 40°C for 3 Hr. After cooling, a methanol was added and cleaning and separating were repeated to obtain 117 g of a siloxane macromer containing a urethane bond. The obtained macromer was subjected to an NMR (nuclear magnetic resonance spectrum) analysis and an IR analysis, and as a result, it was observed that the macromer was a siloxane macromer (molecular weight: 14,500) containing a methacryl urethane group shown in the following formula (macromer A). FIG. 1 shows a 1H-NMR spectrum, and FIG. 2 shows an IR spectrum.

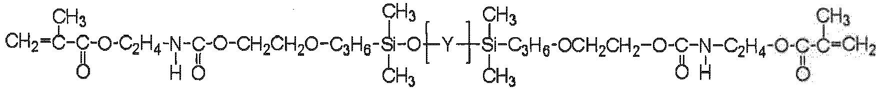

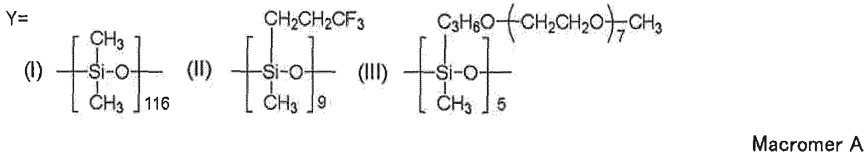

### (Fabrication of Crosslinked Material)

0.5 parts by weight of 2-hydroxy-2-methyl-1-phenyl-propane-1-one (available from BASF Co., Ltd., product name: IRGACURE 1173, hereinafter D1173) was added to 100 parts by weight of the siloxane macromer containing the methacryl urethane group shown in the formula (macromer A), this was stirred in a nitrogen atmosphere, and then the composition (solution before curing) was prepared by defoaming with a centrifuge, and the appearance was observed.

Subsequently, the composition was poured into two glass plates having a Teflon (registered trademark) tape (thickness: 0.5 mm) for adjusting film thickness and a delamination film stuck on the surface, and this was irradiated with 2500 mJ/cm² of an ultraviolet ray in room temperature to obtain a transparent crosslinked material. The oxygen permeation coefficient, mechanical properties, and the contact angle in liquid of the cured film obtained in this manner were measured. Furthermore, a microfluidic channel was fabricated by the same curing method, and then bubble separation property was evaluated. The above results are shown in Table 1.

### [Example 2 and Example 3]

To 90 parts by weight of the siloxane macromer containing the methacryl urethane group shown in the above formula (macromer A), 10 parts by weight of a hydroxyethyl methacrylate (hereinafter, HEMA) or a methacrylic acid (hereinafter, MAA), and 0.5 parts by weight of D1173 were added, a composition was prepared in the same manner as in Example 1, and the appearance was observed. Subsequently, a transparent crosslinked material was obtained by curing in the same manner as in Example 1. The oxygen permeation coefficient, mechanical properties, and the contact angle in liquid of the obtained cured film were measured. Furthermore, a microfluidic channel was fabricated by the same curing method, and then bubble separation property was evaluated. The above results are shown in Table 1.

### [Example 4 and Example 5]

### (Synthesis of Macromer B)

38.6 g of X-22-164 (available from Shin-Etsu Chemical Co., Ltd.), 629 g of octamethylcyclotetrasiloxane, 36 g of 1,3,5,7-tetramethylcyclotetrasiloxane, and 1.4 g of trifluoromethanesulfonic acid were charged into a flask and reaction was conducted at room temperature for 6 Hr.

Subsequently, after neutralizing by adsorbing acid with celite, the solution was refined by distilling off under reduced pressure and dissolved in 300 g of isopropyl alcohol, and a hydrosilylation reaction with 409 g of PKA-5007 (available from NOF Corporation) was performed in the presence of 0.7 g of a platinum catalyst. The obtained reaction solution was repeatedly dissolve-cleaned with an 80% aqueous acetone solution, and then 0.012 g of BHT and 0.006 g of MQ were added, and 706 g of a siloxane macromer having a methacrylic ester group on both terminals was obtained by solvent-distilling. The obtained macromer was subjected to an NMR (nuclear magnetic resonance spectrum) analysis, and as a result, it was observed that the macromer was a siloxane macromer (molecular weight: 10,500), containing a methacrylic ester group as shown in the following formula (macromer B).

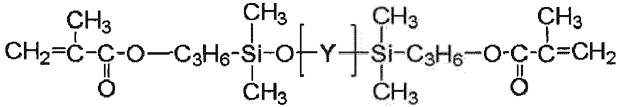

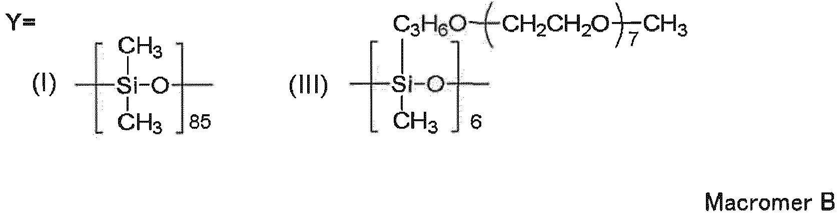

To 90 parts by weight of the siloxane macromer containing the methacrylic ester group shown in the above formula (macromer B), 10 parts by weight of a hydroxyethyl methacrylate (hereinafter, HEMA) or a methacrylic acid (hereinafter, MAA), and 0.5 parts by weight of D1173 were added, a composition was prepared in the same manner as in Example 1, and the appearance was observed. Subsequently, a transparent crosslinked material was obtained by curing in the same manner as in Example 1. The oxygen permeation coefficient, mechanical properties, and the contact angle in liquid of the obtained cured film were measured. Furthermore, a microfluidic channel was fabricated by the same curing method, and then bubble separation property was evaluated. The above results are shown in Table 1.

### [Comparative Example 1]

0.5 parts by weight of D1173 was added to 100 parts by weight of the siloxane macromer (X-22-164E available from Shin-Etsu Chemical Co., Ltd.) shown by the following formula (macromer C), this was stirred in a nitrogen atmosphere, and then the composition (solution before curing) was prepared by defoaming with a centrifuge, and the appearance was observed. Subsequently, a transparent crosslinked material was obtained by curing in the same manner as in Example 1. The oxygen permeation coefficient, mechanical properties, and the contact angle in liquid of the obtained cured film were measured. Furthermore, a microfluidic channel was fabricated by the same curing method, and then bubble separation property was evaluated. The above results are shown in Table 1.

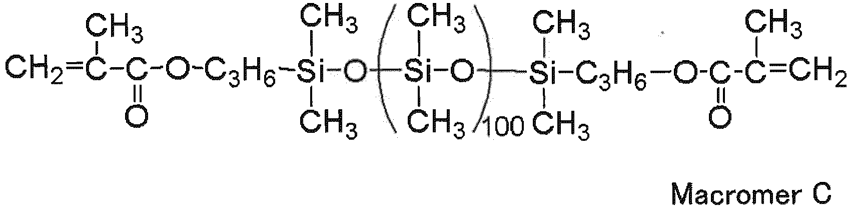

### [Comparative Example 2 and Comparative Example 3]

To 90 parts by weight of the siloxane macromer (X-22-164E available from Shin-Etsu Chemical Co., Ltd.) shown by the above formula (macromer C), 10 parts by weight of a hydroxyethyl methacrylate (hereinafter, HEMA) or a methacrylic acid (hereinafter, MAA), and 0.5 parts by weight of D1173 were added, and this was stirred in a nitrogen atmosphere. In either case, compatibility with a monomer was poor, and it was not possible to obtain a transparent formulation liquid, and therefore, a crosslinked material was not fabricated.

### [Comparative Example 4]

A commercially available Sylgard 184 (available from Dow Corning Corporation) was thermally crosslinked by a known method, and the oxygen permeation coefficient, mechanical properties, and the contact angle in liquid of the obtained cured film were measured. A microfluidic channel was fabricated by the same curing method, and then bubble separation property was evaluated. The above results are shown in Table 1.

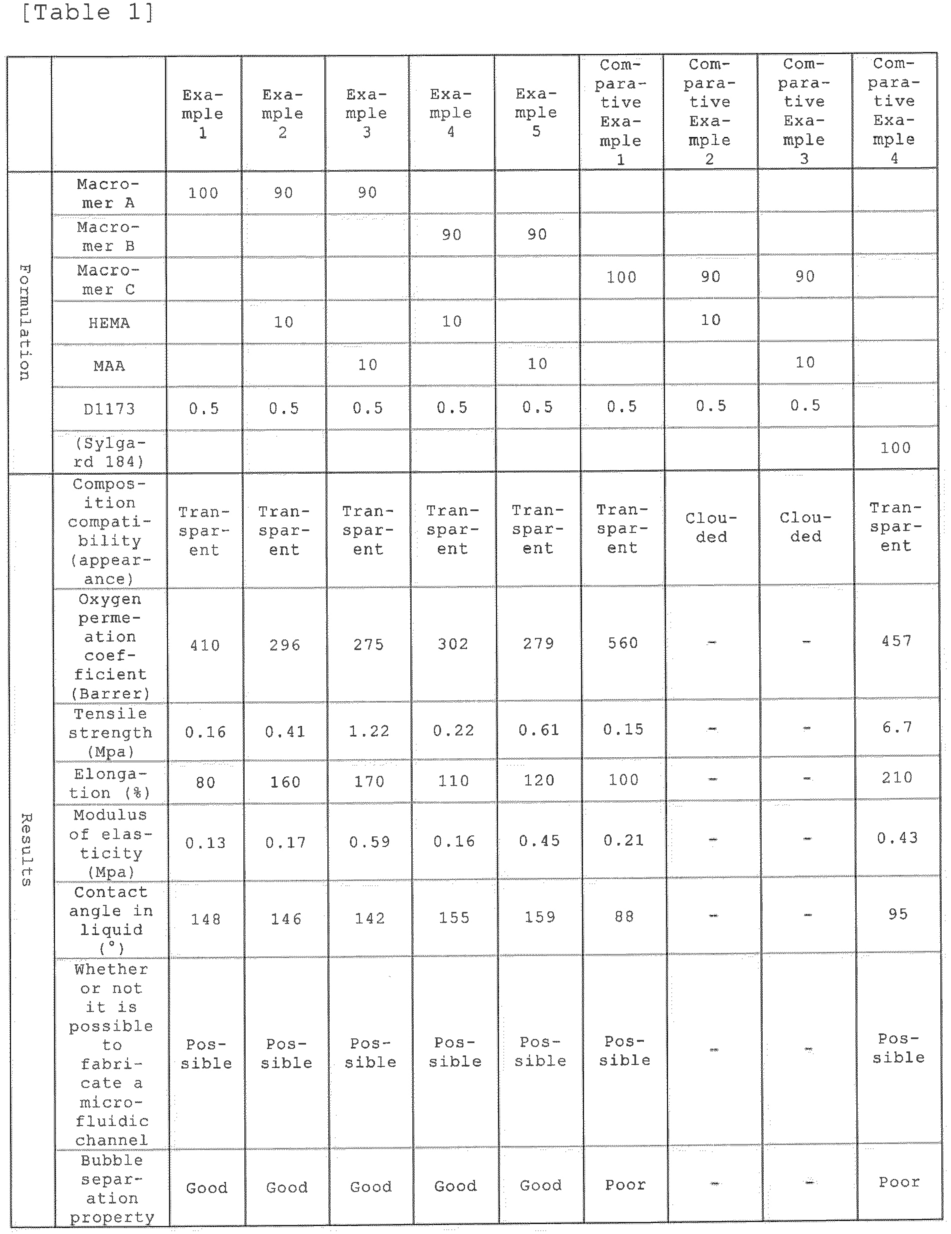

As shown in Table 1, in Examples 1 to 5 of the inventive microfluidic channel made of a hydrophilic silicone resin, it was possible to fabricate a microfluidic channel from every composition, and bubble separation property was also favorable. Accordingly, the surface of the microfluidic channels show high hydrophilicity. In addition, the oxygen permeation coefficient also showed a favorable value. Other physical property values were also sufficient as a microfluidic channel.

On the other hand, in Comparative Example 1, where the macromer C that does not contain a structural unit having a polyalkyleneoxy group on a side chain as in the present invention was used, it was possible to fabricate a microfluidic channel but it was not possible to provide the surface with high hydrophilicity, and bubble separation property was poor. Furthermore, in Comparative Examples 2 and 3, a copolymerizable monomer was blended to the composition in addition to the macromer C in each case, but compatibility was low, and since the appearance of the composition was observed to be clouded, and the composition was not suitable for fabricating a microfluidic channel. Meanwhile, in Comparative Example 4, where a different commercially available product was used, tensile strength, elongation, and modulus of elasticity showed high values, and it was also possible to fabricate a microfluidic channel, but bubble separation property was poor, and high hydrophilicity was not observed.

As described above, it has been made clear that the inventive microfluidic channel made of a hydrophilic silicone resin is a microfluidic channel made from a resin having high oxygen permeability, where a surface after formation shows high hydrophilicity without a secondary treatment and the hydrophilicity is sustained for a long period of time.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A microfluidic channel made of a hydrophilic silicone resin comprising a crosslinked material obtained by curing a composition containing a silicone macromer represented by the following general formula (1), 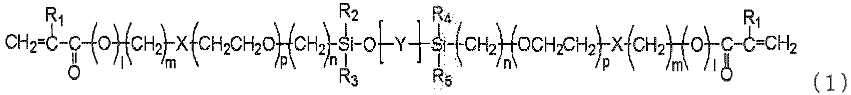 wherein R₁ represents a hydrogen atom or a methyl group; R₂ to R₅ each represents a hydrocarbon group having 1 to 12 carbon atoms or a trimethylsiloxy group; Y consists of structural units (I) to (III) shown in the following general formula (2), where content ratios of the structural units are (I)/(II)=5/5 to 10/0 and [(I)+(II)]/(III)=100/1 to 0/100, and a total number of the structural units contained is (I)+(II)+(III)=1 to 300; "m" and "n" are each an identical or different integer of 0 to 20; "p" is an integer of 0 to 20; "l" is 0 when "m" is 0, and "l" is 1 when "m" is 1 or more; and X represents a single bond, -NHCOO-, or a divalent linking group of -OOCHN-R₁₃-NHCOO- where R₁₃ represents a hydrocarbon group having 4 to 13 carbon atoms, 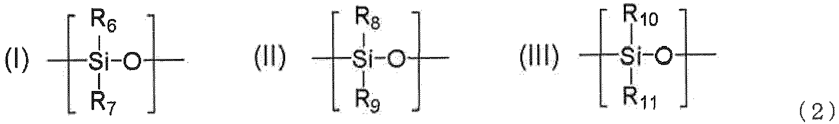 wherein R₆ and R₇ each represents a hydrocarbon group having 1 to 12 carbon atoms; R₈ and R₉ each represents a hydrocarbon group or a hydrocarbon group substituted with a fluorine atom having 1 to 12 carbon atoms, where at least one of R₈ and R₉ represents a hydrocarbon group substituted with a fluorine atom; and R₁₀ and R₁₁ each represents a hydrocarbon group having 1 to 12 carbon atoms or a polyalkyleneoxy group shown in the following general formula (3) where "q" is an integer of 0 to 20 and R₁₂ represents a hydrogen atom or a hydrocarbon group having 1 to 20 carbon atoms, where at least one of R₁₀ and R₁₁ represents a polyalkyleneoxy group.

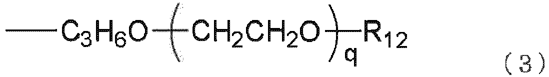

2. The microfluidic channel made of a hydrophilic silicone resin according to claim 1, wherein the composition contains one or more kinds of monomers that are copolymerizable with the silicone macromer.

3. The microfluidic channel made of a hydrophilic silicone resin according to claim 2, wherein the one or more kinds of copolymerizable monomers are one or more kinds of monomers selected from a (meth)acrylate monomer, an N,N-dimethyl(meth)acrylamide monomer, a 2-hydroxyethyl(meth)acrylate monomer, a glycerol(meth)acrylate monomer, a 2-hydroxyethyl(meth)acrylamide monomer, a polyethylene glycol mono(meth)acrylate monomer, an N-vinyl pyrrolidone, and a polyethylene glycol di(meth)acrylate monomer.

4. The microfluidic channel made of a hydrophilic silicone resin according to any one of claims 1 to 3, wherein an underwater contact angle of the crosslinked material is 110° or more.

5. The microfluidic channel made of a hydrophilic silicone resin according to any one of claims 1 to 4, wherein an oxygen permeation coefficient of the crosslinked material is 50 barrers or more.
